Europäisches Patentamt

European Patent Office

Office européen des brevets

(11) Veröffentlichungsnummer : **0 393 520 B1**

(12) # EUROPÄISCHE PATENTSCHRIFT

(45) Veröffentlichungstag der Patentschrift :
18.08.93 Patentblatt 93/33

(51) Int. Cl.⁵ : **C25F 7/00, B41N 3/03**

(21) Anmeldenummer : **90107064.9**

(22) Anmeldetag : **12.04.90**

(54) **Verfahren zum gleichmässigen Einleiten eines Fluids und Vorrichtung zur Durchführung des Verfahrens.**

(30) Priorität : **21.04.89 DE 3913132**

(43) Veröffentlichungstag der Anmeldung :
**24.10.90 Patentblatt 90/43**

(45) Bekanntmachung des Hinweises auf die
Patenterteilung :
**18.08.93 Patentblatt 93/33**

(84) Benannte Vertragsstaaten :
**DE FR GB IT NL**

(56) Entgegenhaltungen :
**DE-A- 2 527 623**

(73) Patentinhaber : **HOECHST
AKTIENGESELLSCHAFT
D-65926 Frankfurt (DE)**

(72) Erfinder : **Stroszynski, Joachim, Dipl.-Ing.
Buchenweg 18
6200 Wiesbaden (DE)**
Erfinder : **Durst, Franz, Prof. Dr.
Eichenstrasse 12
D-8524 Langensendelbach (DE)**
Erfinder : **Interthal, Werner, Dr., Dipl.-Chem.
Dr. Ludwig-Opel-Strasse 62
D-6090 Rüsselsheim (DE)**
Erfinder : **Mack, Gerhard, Dr., Dipl.-Chem.
Mühlstrasse 35b
D-6229 Walluf (DE)**
Erfinder : **Zeisel, Herbert, Dipl.-Ing.
Aegidienberger Strasse 67
D-5340 Bad Honnef 6 (DE)**
Erfinder : **Haas, Raimund, Dr., Dipl.-Ing.
Johannesallee 20
D-6230 Frankfurt/M. 80 (DE)**
Erfinder : **Lehmann, Peter, Dr., Dipl.-Chem.
An der Ziegelei 12
D-6233 Kelkheim (DE)**
Erfinder : **Dammann, Manfred, Dipl.-Ing.
Waldstrasse 25
D-6209 Hohenstein 4 (DE)**

## Beschreibung

Die Erfindung betrifft ein Verfahren zum gleichmäßigen Einleiten eines Fluids in ein Fluidbad mit Hilfe eines über die Mantelfläche perforierten Verteilerrohres sowie eine Vorrichtung zur Durchführung des Verfahrens.

Bei dem Fluid kann es sich um eine Flüssigkeit oder um ein Gas handeln. Insbesondere ermöglicht das Verfahren das gleichmäßige Einleiten von Flüssigkeiten aller Art, wie beispielsweise von Elektrolytlösungen in elektrochemisch arbeitenden Bandanlagen, für die Herstellung von vorbehandelten Aluminiumbändern, aus denen Träger für Offsetdruckplatten gefertigt werden.

Nach dem Verfahren können ebenso entlang von Verteilerrohren gleichmäßige Austrittsgeschwindigkeiten von Gasströmungen erreicht werden.

In der nachfolgenden Beschreibung wird vor allem die Anwendung bei der Vorbehandlung von Aluminiumbändern für Offsetdruckplatten dargestellt. In den Behandlungsstufen des Trägermaterials für Offsetdruckplatten wird das Aluminiumband unter Einwirkung von elektrischem Strom in einer Elektrolytlösung aufgerauht und anschließend anodisiert.

Aufgabe der Erfindung ist es, ein Verfahren zum gleichmäßigen Einleiten einer Flüssigkeit, insbesondere einer Elektrolytlösung, oder eines sonstigen Fluids in ein entsprechendes Bad sicherzustellen, durch das ein aufzurauhendes Bandmaterial hindurchtransportiert wird.

Diese Aufgabe wird verfahrensgemäß in der Weise gelöst, daß der Massenstrom des Fluids beim Eintritt in das Verteilerrohr in Teilströme aufgeteilt und längs zur Rohrachse und über den Umfang des Verteilerrohrs so geführt wird, daß sich quer zur Rohrachse ein gleichmäßig abströmender Volumenstrom einstellt.

Dabei werden die Teilströme längs der und parallel zur Rohrachse in gleichgroße Volumina aufgeteilt. Der Fluidstrom wird nach dem Verfahren an einer Stirnseite in das Verteilerrohr eingeleitet, und es werden der Massenstrom bzw. die Teilströme des Fluids auf den gegenüberliegenden Seiten der Volumina zur Stirnseite abgeschottet und quer zur Rohrachse umgelenkt.

In Ausgestaltung des Verfahrens wird jeder der umgelenkten Teilströme längs eines Einlaufsektors und über den Innenumfang des Verteilerrohrs strömungsmäßig verteilt, bevor er aus den Perforationen des Verteilerrohrs austritt.

In einer anderen Ausgestaltung des Verfahrens findet der Massenstrom des Fluids im Verteilerrohrinneren über die Einlauflänge des Verteilerrohrs in axialer wie radialer Strömungsrichtung gleiche Druckverhältnisse vor. Dabei wird der Strömungsdruck des Fluids über die Länge des Verteilerrohrs durch geeignete Rohreinbauten, die einen abnehmenden Durchflußquerschnitt des Verteilerrohres bewirken, konstant gehalten.

Eine der Vorrichtungen zur Durchführung des Verfahrens, mit einem über die Mantelfläche perforierten Verteilerrohr, zeichnet sich dadurch aus, daß das perforierte Verteilerrohr ein Hüllrohr umschließt, das in Strömungskammern unterteilt ist, und daß jede Strömungskammer von zwei Kreisringplatten begrenzt ist und mit einem Einlaufsektor verbunden ist und daß an der Einlaufseite des Verteilerrohrs ein Volumenstromverteiler als Rohreinsatz angeordnet ist, der den eingeleiteten Massenstrom in Teilströme für die Strömungskammern aufteilt.

Eine weitere Vorrichtung zur Durchführung des Verfahrens mit einem über die Mantelfläche perforierten Verteilerrohr zeichnet sich dadurch aus, daß das perforierte Verteilerrohr einen rotationssymmetrischen Druckverteiler umschließt, der im Verteilerrohr sternförmig durch Rippen zentriert ist, einen von der Eintrittsöffnung zu der Abschlußstirnfläche zunehmenden Durchmesser aufweist und an der Abschlußstirnfläche ansetzt.

Mit der Erfindung wird der Vorteil erzielt, daß die Elektrolytlösung sehr gleichmäßig über die Breite in das jeweilige Elektrolytlösungsbad einer Behandlungsstufe einfließt, was besonders wichtig bei Hochleistungsbehandlungsstufen ist, die einen großen Elektrolytlösungsdurchsatz erfordern, um die Gleichmäßigkeit der elektrochemischen Aufrauhung über die Trägerbreite sicherzustellen.

Die Erfindung wird im folgenden anhand der Zeichnungen näher erläutert. Es zeigen:

Figur 1    schematisch ein Verteilerrohr nach der Erfindung in einem Elektrolytbadbehälter, durch den ein zu behandelndes Trägerband hindurchläuft,

Figur 2    eine perspektivische Ansicht einer teilweise aufgebrochenen Ausführungsform des Verteilerrohrs nach der Erfindung,

Figur 3    einen Schnitt längs der Linie I-I in Figur 2,

Figur 4    eine perspektivische Ansicht einer anderen, teilweise aufgebrochenen Ausführungsform des Verteilerrohrs, mit abgestuftem Druckverteiler nach der Erfindung,

Figur 5    einen Schnitt längs der Linie II-II in Figur 4,

Figur 6    eine Ansicht eines Rotationsparaboloids, das als Druckverteiler in einem Verteilerrohr eingesetzt wird, und

Figur 7    eine Ansicht eines Kegels, der als Druckverteiler in einem Verteilerrohr zum Einsatz kommt.

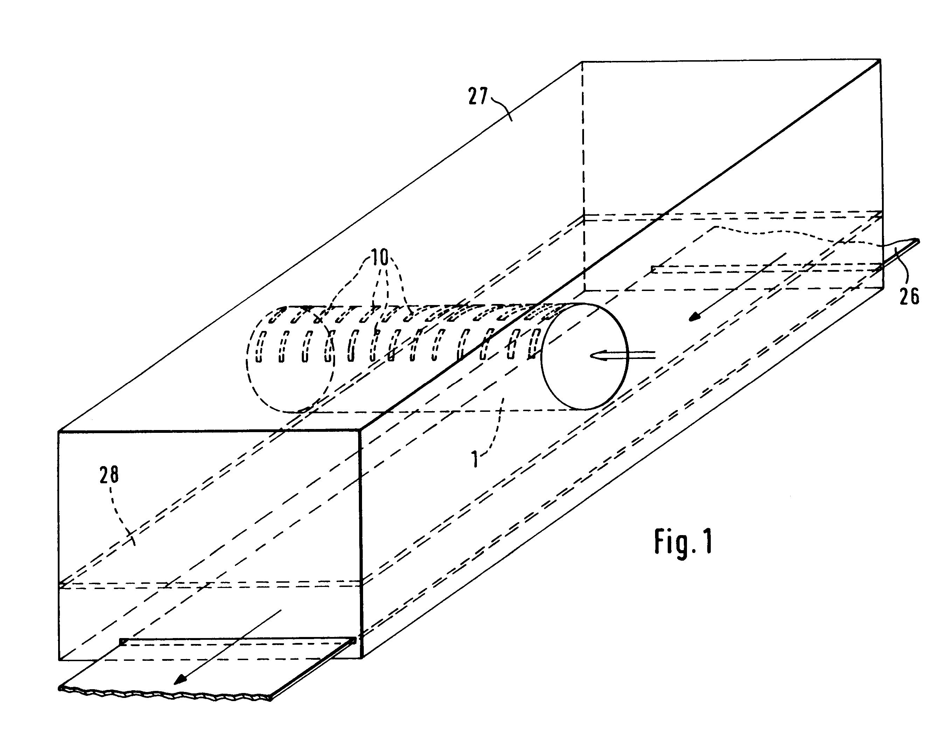

In Figur 1 ist schematisch in perspektivischer Ansicht ein Behälter 27 für ein Fluid, beispielsweise für eine Elektrolytlösung, dargestellt. Diese Elektrolytlösung bildet, zusammen mit nichteingezeichneten Elektroden, ein Elektrolytbad 28 in dem Behälter, durch den, am Eingangs- und Ausgangsspalt abgedichtet, ein Band 26 aus Trägermaterial für Druckplatten hindurchläuft. Dieses Trägerband ist im allgemeinen ein Metallband, beispielsweise Aluminiumband, dessen Oberfläche nach einem mechanischen Aufrauhen zusätzlich elektrochemisch aufgerauht und anschließend anodisiert wird. In dem Behälter 27 ist ein perforiertes Verteilerrohr 1 quer zur Laufrichtung des Bandes 26 angeordnet. In das Verteilerrohr 1 wird von einer Seite die Elektrolytlösung eingeleitet, die beispielsweise durch Rohrschlitze 10 in der Umfangsfläche des Verteilerrohrs 1 austritt. Mit dem Verteilerrohr 1 wird ein gleichmäßiges Austreten bzw. Einleiten der Elektrolytflüssigkeit entlang des Verteilerrohrs in das Elektrolytbad 28 realisiert, wie nachstehend noch näher beschrieben werden wird.

Die Wirkungsweise des Verteilerrohrs 1 wird anhand von eingeleiteter Elektrolytflüssigkeit bzw. Flüssigkeit erläutert, jedoch haben spezifische Untersuchungen gezeigt, daß ein derartiges Verteilerrohr mit gleichem Erfolg für Gase eingesetzt werden kann, die einseitig in das Verteilerrohr 1 eingeleitet werden und sehr gleichmäßig verteilt entlang des Verteilerrohrs 1 aus den Rohrschlitzen 10 austreten sollen.

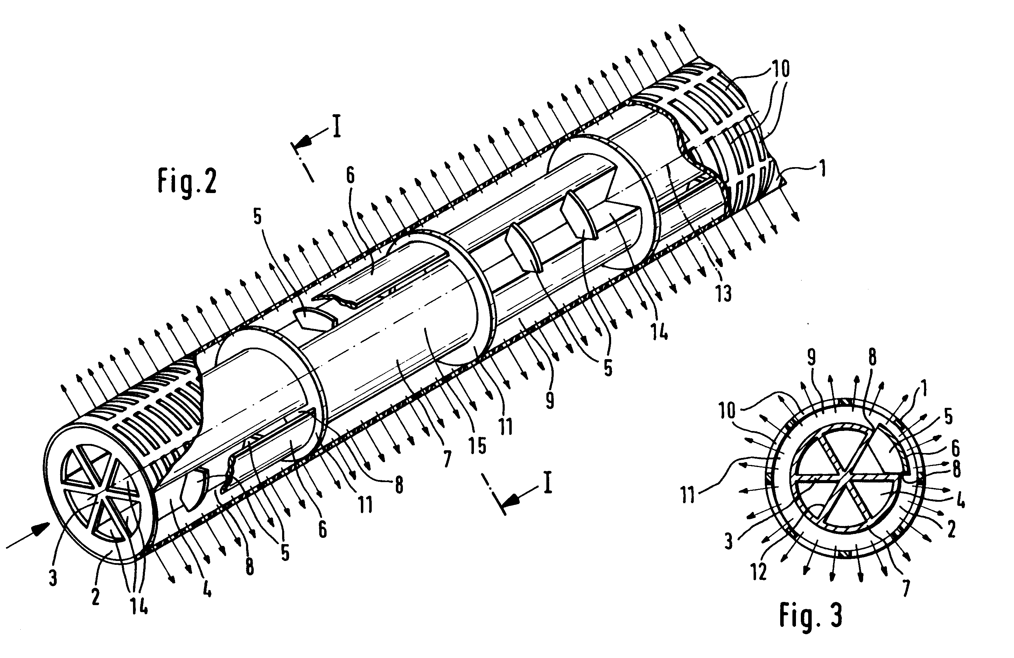

Figur 2 zeigt eine perspektivische Ansicht einer teilweise aufgebrochenen Ausführungsform des Verteilerrohrs 1, das in seiner Umfangsfläche die Rohrschlitze 10 aufweist, die quer zur Rohrachse 13 in der Umfangsfläche des Verteilerrohrs 1 verlaufen. Die Rohrschlitze 10 sind gleichmäßig über, die Umfangsfläche und über die Länge des Verteilerrohrs 1 verteilt, das ein Hüllrohr 7 umschließt, welches in Strömungskammern 4 unterteilt ist. An der Einlaufseite des Verteilerrohrs 1 ist ein Volumenstromverteiler 2 als Rohreinsatz angeordnet, der beispielsweise einen sechs- oder achtsternigen Rohreinsatz mit radialen Verteilerstegen 3 darstellt. Der Volumenstromverteiler teilt den eingeleiteten Gesamtmassenstrom in Teilströme auf, die in die Strömungskammern 4 einströmen. Jede der Strömungskammern 4 wird von zwei Kreisringplatten 11, 11 begrenzt. Der Volumenstromverteiler 2 teilt den Querschnitt des eingeleiteten Massenstroms durch die Verteilerstege 3 in sechs oder acht gleichgroße Einzel-Einströmquerschnitte auf, von denen jeder die Eintrittsöffnung eines Einlaufsektors 14 bildet, der in die zugehörige Strömungskammer 4 führt.

Der Volumenstromverteiler 2 ist in axialer Richtung, d.h. längs zur Rohrachse 13, in sechs oder acht entsprechende Strömungskammern 4 aufgeteilt, die jeweils für sich von einem der Einlaufsektoren 14 versorgt werden und durch die Kreisringplatten 11 abschnittsweise abgeschottet sind.

Zwischen der Innenseite des Verteilerrohrs 1 und dem Hüllrohr 7 befindet sich ein Ringraum 9, der sich durch die Kreisringplatten 11 in sechs bzw. acht Einzel-Ringräume unterteilt. Jede Strömungskammer 4 weist eine Prallplatte 6 auf, die sich längs der und parallel zu der Rohrachse 13 über den Einlaufsektor 14 erstreckt und mit Kammerwänden 12, 12 des Einlaufsektors 14 zwei zueinander parallele Austrittsschlitze 8 der Strömungskammer 4 bildet. Die Strömungskammern 4 sind mit ihren Austrittsschlitzen 8, die in den Ringraum 9 münden, zum Verteilerrohr 1 hin orientiert und haben quer zur Strömungsrichtung jeweils zwei Stützflächen 5, auf denen die Prallplatte 6 aufliegt. Die Stützflächen 5, die den Strömungsquerschnitt der sektorförmigen Strömungskammer 4 teilweise einengen, bewirken eine örtliche Strömungsverteilung längs der Strömungskammer und nehmen gleichzeitig die Prallplatte 6 auf, die oberhalb der Austrittsschlitze 8 angebracht ist. Der Austritt des Fluids, ob es sich nun um eine Elektrolytlösung oder um ein Gas handelt, aus der Strömungskammer 4, erfolgt in Umfangsrichtung des Hüllrohres 7 nach beiden Seiten durch die Austrittsschlitze 8.

In der Schnittdarstellung der Figur 3 längs der Linie I-I der Ausführungsform nach Figur 2 ist ersichtlich, daß die zwei Stützflächen 5 quer zur Strömungsrichtung angeordnet sind und über die Umfangsfläche des Hüllrohrs 7 vorstehen, so daß sich zwischen der Prallplatte 6 und den Kammerwänden 12 einer Strömungskammer 4 die beiden Austrittsschlitze 8, 8 auftun. Die Austrittsschlitze 8 geben die Strömung in tangentialer Richtung frei. Im Ringraum 9 zwischen dem Verteilerrohr 1 und dem Hüllrohr 7 wird die Strömung über den Umfang des Hüllrohrs 7, ausgenommen das Totgebiet hinter der Prallplatte 6, gleichmäßig verteilt. Obgleich dies in den Figuren 2 und 3 nicht gezeigt ist, kann die Prallplatte 6 perforiert ausgebildet sein, wodurch dann das erwähnte Totgebiet eliminiert wird und auch in diesem Bereich eine Strömung über den Umfang der Prallplatte 6 im Ringraum 9 ausgebildet wird.

Aus dem Ringraum 9 tritt das Fluid, beispielsweise die Elektrolytlösung, über die Rohrschlitze 10 im Verteilerrohr 1 mit gleicher Geschwindigkeit und unter gleichem Innendruck nach außen. In Axialrichtung sind die Austrittsschlitze 8 im Hüllrohr 7 versetzt angeordnet. Die am Anfang bzw. am Ende jeder Strömungskammer 4 vorhandenen Kreisringplatten 11 zentrieren den Volumenstromverteiler 2 mit dem Verteilerrohr 1. Das Material des gesamten Einlaufrohrsystems aus Verteilerrohr 1, Volumenstromverteiler 2, Strömungskammern 4, Hüllrohr 7 und den sonstigen Bestandteilen wird zweckmäßigerweise aus säurebeständigem Kunststoff, wie beispielsweise Polypropylen oder Polyvinylchlorid, hergestellt.

Der Fluid- bzw. Flüssigkeitsstrom wird an einer Stirnseite in das Verteilerrohr 1 eingeleitet, und die Teilströme in den einzelnen Strömungskammern 4 werden quer zur Rohrachse 13 umgelenkt. Jeder der umgelenkten Teilströme wird über den Innenumfang des Verteilerrohrs 1 gleichmäßig verteilt, bevor er aus den Rohrschlitzen 10 des Verteilerrohrs 1 austritt.

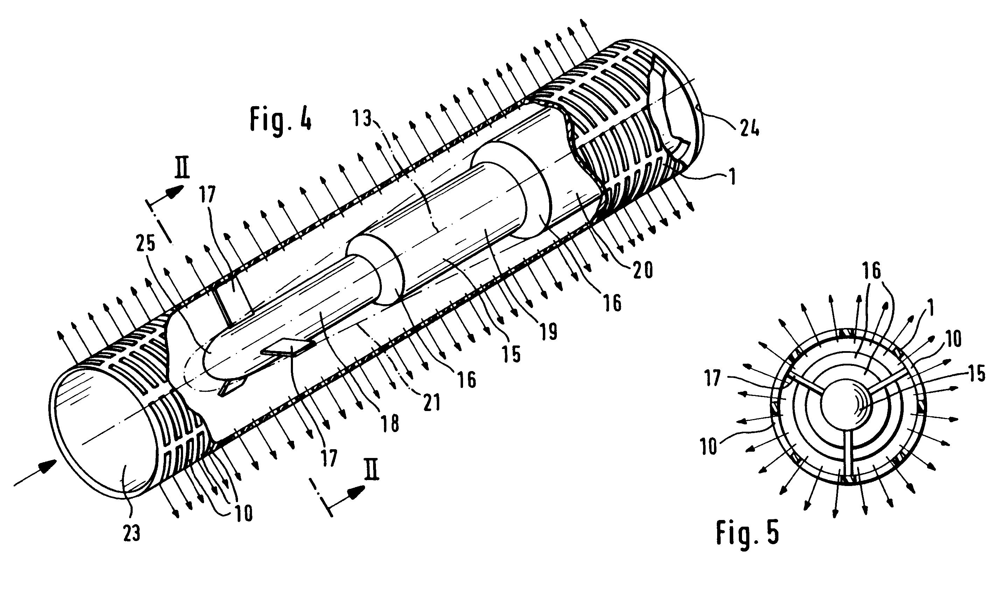

In Figur 4 ist eine perspektivische Ansicht einer weiteren, teilweise aufgebrochenen Ausführungsform des Verteilerrohrs 1 dargestellt. Das durch die Rohrschlitze 10 perforierte Verteilerrohr 1 umschließt einen rotationssymmetrischen Druckverteiler 15, der im Verteilerrohr 1 sternförmig durch Rippen 17 zentriert ist. Der Druckverteiler 15 besitzt einen von einer Eintrittsöffnung 23 für das Fluid zu einer Abschlußstirnfläche 24 des Verteilerrohrs 1 zunehmenden Durchmesser und setzt unmittelbar an der Abschlußstirnfläche 24 an. Durch den ansteigenden Durchmesser des Druckverteilers 15 im Inneren des Verteilerrohrs 1 wird der Flüssigkeitsdruck im Rohrinneren vergleichmäßigt. Der Druckverteiler 15 besteht aus mehreren Druckverteilerstufen 18, 19, 20, beispielsweise in Zylinderform, die durch kegelstumpfartige Bünde 16 miteinander verbunden sind. Den zur Eintrittsöffnung 23 des Verteilerrohrs 1 nächstliegenden Zylinder 18 schließt ein Rotationsparaboloid 25 ab. Der Druckverteiler 15 bewirkt eine gleichmäßige Druckverteilung in axialer und radialer Strömungsrichtung. Die einzelnen Druckverteilerstufen können auch unterschiedliche Gestalt haben, beispielsweise kann die Druckverteilerstufe 20 ein Kegelstumpf sein, während die übrigen Druckverteilerstufen 18 und 19 Zylinder sind. Ebenso ist eine Ausführungsform möglich, bei der alle Druckverteilerstufen aus Kegelstümpfen bestehen und darüber hinaus durch die kegelstumpfartigen Bünde 16 miteinander verbunden sind. Wesentlich ist dabei nur, daß der Druckverteiler 15 so ausgelegt ist, daß die Druckverteilung im durchströmenden Fluid bzw. in der einströmenden Flüssigkeit, im Spalt zwischen der Innenseite des Verteilerrohrs 1 und den Mantelflächen der Druckverteilerstufen bzw. der Mantelfläche des gesamten Druckverteilers 15, isobar ist. Wie aus der Schnittdarstellung der Figur 5 ersichtlich ist, tritt das Fluid bzw. die Flüssigkeit radial aus den Rohrschlitzen 10 des Verteilerrohrs 1 mit gleichmäßigem Innendruck bzw. gleichmäßiger Geschwindigkeit aus.

Ausführungsbeispiel:

Für ein seitliches Einleiten einer Flüssigkeit in das Verteilerrohr 1, z.B. 225 m³/h, kann dieses folgende Abmessungen aufweisen, die ausreichend für eine drallfreie und gleichmäßige Verteilung über die Rohrachse des perforierten Verteilerrohrs 1 sorgen:

| | |
|---|---|
| Innendurchmesser | 200 mm |
| Länge | 1.690 mm |
| Wandstärke | 12 mm |
| Länge der Rohrschlitze 10 | 74 mm |
| Breite der Rohrschlitze | 3 mm |
| Teilung der Rohrschlitze | 16 mm |

Die Rohrschlitze 10 sind in Reihen quer zur Rohrachse in der Umfangsfläche des Verteilerrohrs 1 angeordnet.

Abmessungen eines 4-stufigen Druckverteilers 15:

Die Länge des gesamten Druckverteilers beträgt 1.450 mm.

Der Druckverteiler 15 ist am hinteren Ende des Verteilerrohres 1 angesetzt.

Abmessungen der einzelnen Druckverteilerstufen von der Abschlußstirnfläche 24 zu der Eintrittsöffnung 23 hin:

| | Durchmesser | Länge |
|---|---|---|
| 1. Druckverteilerstufe | 160 mm | 150 mm |
| 2. Druckverteilerstufe | 110 mm | 600 mm |
| 3. Druckverteilerstufe | 90 mm | 400 mm |
| 4. Druckverteilerstufe | 63 mm | 300 mm |

Die Übergänge von einer Druckverteilerstufe zur anderen haben die Form von Kegelstümpfen.

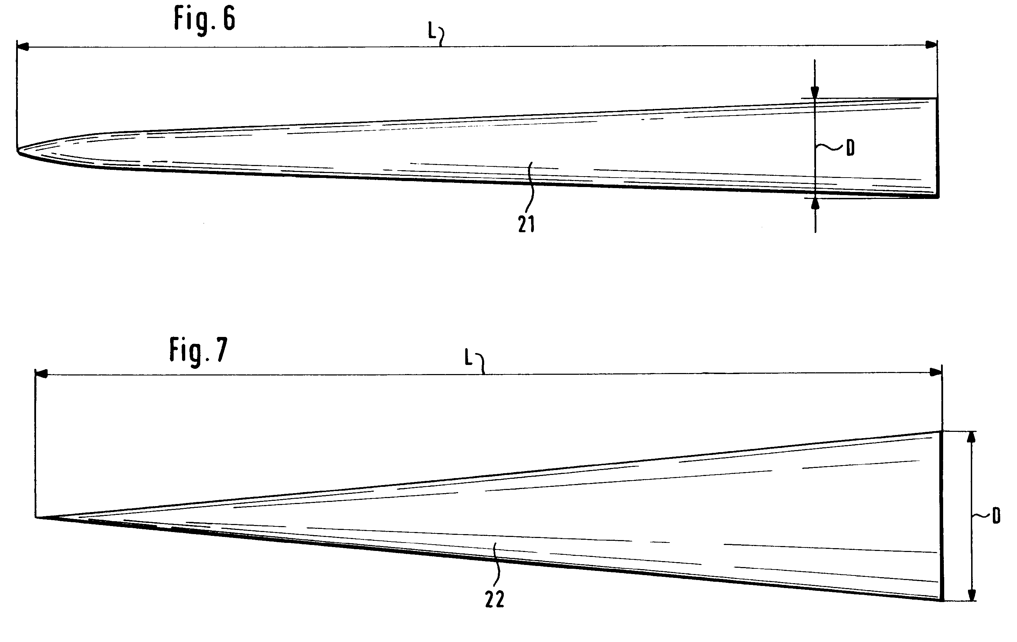

In Figur 6 ist eine weitere Ausführungsform eines Druckverteilers 21 schematisch gezeigt, wobei es sich bei diesem Druckverteiler 21 um ein einteiliges Rotationsparaboloid handelt. Zu einem bestimmten lokalen Längenabschnitt k des Rotationsparaboloids an der Stelle i gehört ein Innendurchmesser $d_i$ gemäß der Gleichung

$$d_i^2 = d_0^2 + iD^2/n$$

mit der Anzahl n = L/k der Längenabschnitte k, i = 0,1, 2,3,...n, bei vorgegebener Gesamtlänge L des Druckverteilers 21, maximalem Innendurchmesser D des Verteilerrohrs 1 bzw. maximalem Außendurchmesser des Druckverteilers 21 und einer vorgegebenen Länge eines Längenabschnittes k von 10 mm. In der voranstehenden Gleichung ist $d_0$ der kleinste Durchmesser des Druckverteilers 21 für i = 0, d.h. daß er einen Wert gleich 0 mm hat, wenn die Zählung i der aneinandergereihten Längenabschnitte k in der Spitze des Druckverteilers 21 begonnen wird und in Richtung des maximalen Außendurchmessers D des Druckverteilers 21 die Zählung fortgeführt wird, wobei i eine fortlaufende Numerierung von 0, 1, 2...n ist.

Die obige Gleichung für den lokalen Innendurchmesser $d_i$ folgt aus der Gleichung

$$d_i^2 - d_{i-1}^2 = D^2/n,$$

in dem in dieser Gleichung für kleiner werdendes i jeweils der entsprechende Wert neu eingesetzt wird. Es ergibt sich dann

$$d_i^2 = D^2/n + d_{i-1}^2$$
$$d_{i-1}^2 = D^2/n + D_{i-2}^2$$
$$d_{i-(i-1)}^2 = D^2/n + d_{i-[(i-1)+1]}^2$$

$$d_i^2 = \underbrace{D^2/n + D^2/n + \ldots D^2/n}_{i-mal} + d_0^2$$

$$d_i^2 = d_0^2 + iD^2/n.$$

Über die so erhaltenen lokalen Durchmesser $d_i$ des Rotationsparaboloids kann bei genügend hoher Segmentanzahl n die Einhüllende des Verdrängungskörpers konstruiert und gefertigt werden.

Nachstehend werden die Abmessungen eines perforierten Verteilerrohres 1 und eines Druckverteilers 21 wie folgt angegeben:

| | |
|---|---|
| Maximaler Innendurchmesser D | 143 mm |
| Druckverteilerlänge L | 1.400 mm |
| Wandstärke | 12 mm |
| Rohrschlitzlänge | 74 mm |
| Rohrschlitzbreite | 3 mm |
| Teilung der Rohrschlitze | 16 mm. |

Der jeweilige mittlere Innendurchmesser eines Längenabschnitts k des rotationsparabolischen Druckverteilers 21 ergibt sich gemäß der Beziehung

$$d_i^2 - d_{i-1}^2 = D^2/n.$$

Diese Beziehung liefert für n = 140 (n = Länge/k = 1400 mm/10 mm = 140) den zugehörigen Innendurchmesser $d_i = \sqrt{146{,}0643 + d_{i-1}^2}$ , wenn der Durchmesser in mm eingesetzt wird.

Eine weitere Ausführungsform eines Druckverteilers 22 ist schematisch in Figur 7 gezeigt. Dabei handelt es sich um einen rotationssymmetrischen Kegel der Druckverteilerlänge L und des maximalen Innendurchmessers D des Verteilerrohrs 1 bzw. des maximalen Außendurchmessers des Druckverteilers 22. Der Druckverteiler 22 ist ebenso wie der Druckverteiler 21 nach Figur 6 jeweils direkt an der Innenseite der Abschlußstirnfläche 24 (vgl. Figur 4) angebracht. Die Druckverteilung im Inneren des Verteilerrohrs 1 bei Einsatz eines rein kegelförmigen Druckverteilers 22 weicht geringfügig von der gleichförmigen Druckverteilung bei Verwendung eines streng rotationsparabolischen Druckverteilers 21 ab, jedoch liegt diese geringfügige Ungleichmäßigkeit der Druckverteilung im Rahmen der Toleranzgrenze für den praktischen Betrieb. Der Vorteil des rein kegelförmigen Druckverteilers 22 gegenüber dem rotationsparabolischen Druckverteiler 21 liegt in der einfacheren Fertigung.

**Patentansprüche**

1. Verfahren zum gleichmäßigen Einleiten eines Fluids in ein Fluidbad mit Hilfe eines über die Mantelfläche perforierten Verteilerrohrs, dadurch gekennzeichnet, daß der Massenstrom des Fluids beim Eintritt in das Verteilerrohr in Teilströme aufgeteilt und längs zur Rohrachse und über den Umfang des Verteilerrohrs so geführt wird, daß sich quer zur Rohrachse ein gleichmäßig abströmender Volumenstrom einstellt.

2. Verfahren nach Anspruch 1, dadruch gekennzeichnet, daß die Teilströme längs der und parallel zur Rohrachse in gleichgroße Volumina aufgeteilt werden.

3. Verfahren nach Anspruch 2, dadurch gekennzeichnet, daß der Fluidstrom an einer Stirnseite in das Verteilerrohr eingeleitet wird und daß der Massenstrom bzw. die Teilströme des Fluids auf den gegenüberliegenden Seiten der Volumina zur Stirnseite abgeschottet und quer zur Rohrachse umgelenkt werden.

4. Verfahren nach Anspruch 3, dadurch gekennzeichnet, daß jeder der umgelenkten Teilströme längs eines Einlaufsektors und über den Innenumfang des Verteilerrohrs strömungsmäßig verteilt wird, bevor er aus den Perforationen des Verteilerrohrs austritt.

5. Verfahren zum gleichmäßigen Einleiten eines Fluids in ein Fluidbad mit Hilfe eines über die Mantelfläche perforierten Verteilerrohrs, dadurch gekennzeichnet, daß der Massenstrom des Fluids im Verteilerrohrinneren über die Einlauflänge des Verteilerrohrs in axialer wie radialer Strömungsrichtung gleiche Druckverhältnisse vorfindet.

6. Verfahren nach Anspruch 5, dadurch gekennzeichnet, daß der Strömungsdruck des Fluids über die Länge des Verteilerrohrs durch geeignete Rohreinbauten mit abnehmendem Durchflußquerschnitt konstant gehalten wird.

7. Vorrichtung zur Durchführung des Verfahrens nach einem oder mehreren der Ansprüche 1 bis 4, mit einem über die Mantelfläche perforierten Verteilerrohr, dadurch gekennzeichnet, daß das perforierte Verteilerrohr (1) ein Hüllrohr (7) umschließt, das in Strömungskammern (4) unterteilt ist, daß jede Strömungskammer (4) von zwei Kreisringplatten (11) begrenzt ist und mit einem Einlaufsektor (14) verbunden ist und daß an der Einlaufseite des Verteilerrohrs (1) ein Volumenstromverteiler (2) als Rohreinsatz angeordnet ist, der den eingeleiteten Massenstrom in Teilströme für die Strömungskammern aufteilt.

8. Vorrichtung nach Anspruch 7, dadurch gekennzeichnet, daß der Volumenstromverteiler (2) ein sechs- bis achtsterniger Rohreinsatz mit radialen Verteilerstegen (3) ist, die von einem gemeinsamen Mittelpunkt ausgehen, und daß der Rohreinsatz den Querschnitt des eingeleiteten Massenstroms durch die Verteilerstege (3) in sechs bis acht gleichgroße Einströmquerschnitte aufteilt.

9. Vorrichtung nach Anspruch 8, dadurch gekennzeichnet, daß jeder Einströmquerschnitt die Eintrittsöffnung eines Einlaufsektors (14) bildet, der in die zugehörige Strömungskammer (4) führt, und daß die Strömungskammern (4) gleichlang sind, wobei jede Strömungskammer (4) eine Prallplatte (6) aufweist, die sich längs und parallel zu der Rohrachse (13) über den Einlaufsektor (14) erstreckt und mit Kammerwänden (12) des Einlaufsektors (14) zwei zueinander parallele Austrittsschlitze (8) der Strömungskammer (4) bildet, die in einem Ringraum (9) zwischen dem Verteiler- (1) und dem Hüllrohr (7) münden.

10. Vorrichtung nach Anspruch 7, dadurch gekennzeichnet, daß in jedem Einlaufsektor (14) quer zur Strömungsrichtung zwei Stützflächen (5) angeordnet sind, die über die Umfangsfläche des Hüllrohrs (7) vorstehen und auf denen sich die Prallplatte (6) abstützt.

11. Vorrichtung nach Anspruch 10, dadurch gekennzeichnet, daß die Prallplatte (9) perforiert ist.

12. Vorrichtung nach Anspruch 7, dadurch gekennzeichnet, daß die Kreisringplatten (11) den Volumenstromverteiler (2) mit dem Verteilerrohr (1) zentrieren.

13. Vorrichtung nach Anspruch 7, dadurch gekennzeichnet, daß Rohrschlitze (10), die quer zur Rohrachse (13) in der Mantelfläche des Verteilerrohrs (1) verlaufen, die Perforationen des Verteilerrohrs bilden.

14. Vorrichtung nach Anspruch 7, dadurch gekennzeichnet, daß die Strömungskammern (4) längs der Rohrachse (13) sternförmig versetzt sind.

15. Vorrichtung zur Durchführung des Verfahrens nach den Ansprüchen 5 und 6, mit einem über die Mantelfläche perforierten Verteilerrohr, dadurch gekennzeichnet, daß das perforierte Verteilerrohr (1) einen rotationssymmetrischen Druckverteiler (15; 21; 22) umschließt, der im Verteilerrohr (1) sternförmig durch Rippen (17) zentriert ist, einen von der Eintrittsöffnung (23) zu der Abschlußstirnfläche (24) zunehmenden Durchmesser aufweist und an der Abschlußstirnfläche (24) ansetzt.

16. Vorrichtung nach Anspruch 15, dadurch gekennzeichnet, daß der Druckverteiler (15) aus mehreren Druckverteilerstufen (18, 19, 20) besteht, daß die Druckverteilerstufen (18, 19, 20) Zylinder sind und durch kegelstumpfartige Bünde (16) miteinander verbunden sind und daß der zur Eintrittsöffnung (23) nächstgelegene Zylinder (18) von einem Rotationsparaboloid (25) abgeschlossen ist.

17. Vorrichtung nach Anspruch 15, dadurch gekennzeichnet, daß der Druckverteiler (15; 21; 22) so aus gelegt ist, daß die Druckverteilung im einströmenden Fluid im Spalt zwischen der Innenseite des Verteilerrohrs (1) und der Mantelfläche des Druckverteilers isobar ist.

18. Vorrichtung nach Anspruch 15, dadurch gekennzeichnet, daß der Druckverteiler (21) aus einem einteiligen Rotationsparaboloid besteht, dessen zu einem bestimmten Längenabschnitt k gehörender Innendurchmesser $d_i$ gemäß der Gleichung $d_i^2 = d_0^2 + iD^2/n$, mit der Anzahl n = L/k der Längenabschnitte k, bei vorgegebener Gesamtlänge L, maximalem Innendurchmesser D, einer vorgegebenen Länge eines Längenabschnitts k von 10 mm, und i = 0,1,2,...n bestimmt wird.

19. Vorrichtung nach Anspruch 15, dadurch gekennzeichnet, daß der rotationssymmetrische Druckverteiler (22) ein Kegel ist.

## Claims

1. A process for the uniform introduction of a fluid into a fluid bath by means of a distributor tube which is perforated over its shell surface, wherein the mass stream of the fluid is divided into partial streams on entry into the distributor tube and is guided longitudinally of the tube axis and over the periphery of the distributor tube such that a uniformly outflowing volume flow is set up transversely of the tube axis.

2. The process as claimed in claim 1, wherein the partial streams are divided up along and parallel to the tube axis into equal volume.

3. The process as claimed in claim 2, wherein the fluid stream is introduced into the distributor tube at one end and wherein the mass stream or the partial streams of the fluid are bulkheaded at the ends of the volumes opposite to the first end and are deflected transversely of the tube axis.

4. The process as claimed in claim 3, wherein each of the deflected partial streams is distributed, as regards flow, along an inlet sector and over the inner periphery of the distributor tube, before it exits from the perforations of the distributor tube.

5. A process for the uniform introduction of a fluid into a fluid bath by means of a distributor tube which is perforated over its shell surface, wherein the mass stream of the fluid within the distributor tube encounters like pressure conditions in the axial and radial flow directions over the inlet length of the distributor tube.

6. The process as claimed in claim 5, wherein the flow pressure of the fluid is kept constant over the length of the distributor tube by suitable tube inserts with decreasing througflow cross section.

7. An apparatus for carrying out the process as claimed in one or more of claims 1-4, with a distributor tube perforated over its shell surface, wherein the perforated distributor tube (1) encloses a casing tube (7) which is divided into flow chambers (4), and wherein each flow chamber (4) is bounded by two annular plates (11) and is connected to an inlet sector (14), and wherein a volume flow divider (2) is arranged on the inlet side of the distributor tube (1) as a tube insert which divides the introduced mass stream into partial streams for the flow chambers.

8. The apparatus as claimed in claim 7, wherein the volume flow distributor (2) is a six-star to eight-star tube insert with radial distributor ribs (3), which extend from a common midpoint, and wherein the tube insert divides the cross section of the introduced mass stream, by means of the distributor ribs (3), into six to eight equally large inflow cross sections.

9. The apparatus as claimed in claim 8, wherein each inflow cross section forms the inlet opening of an inlet sector (14), which leads into the associated flow chamber (4), and wherein the flow chambers (4) are of equal length, each flow chamber (4) having a baffle plate (6) which extends along, and parallel to, the tube axis (13) over the inlet sector (14), and forms, with chamber walls (12) of the inlet sector (14), two mutually parallel exit slots (8) of the flow chamber (4) which exit slots (8) open into an annular space (9), between the distributor tube (1) and the casing tube (7).

10. The apparatus as claimed in claim 7, wherein in each inlet sector (14) there are arranged, transversely of the flow direction, two support surfaces (5) which stand out over the peripheral surface of the casing tube (7) and on which the baffle plate (6) is supported.

11. The apparatus as claimed in claim 10, wherein the baffle plate (6) is perforated.

12. The apparatus as claimed in claim 7, wherein the annular plates (11) center the volume flow distributor (2) relative to the distributor tube (1).

13. The apparatus as claimed in claim 7, wherein tube slots (10), which run transversely of the tube axis (13) in the shell surface of the distributor tube (1), form the perforations of the distributor tube.

14. The apparatus as claimed in claim 7, wherein the flow chambers (4) are offset in a star shape along the tube axis (13).

15. An apparatus for carrying out the process as claimed in claims 5 and 6, comprising a distributor tube perforated over its shell surface, wherein the perforated distributor tube (1) encloses a rotationally symmetrical pressure distributor (15; 21; 22), which is centered in the distributor tube (1) by ribs (17) in a star shape, has a diameter which increases from the inlet opening (23) to the end face (24), and is joined to the end face (24).

16. The apparatus as claimed in claim 15, wherein the pressure distributor (15) consists of several pressure distributor stages (18, 19, 20), wherein the pressure distributor stages (18, 19, 20) are cylindrical and are connected together by frustroconical joints (16), and wherein the cylinder (18) nearest to the inlet opening (23) is occluded by a paraboloid of revolution (25).

17. The apparatus as claimed in claim 15, wherein the pressure distributor (15; 21; 22) is designed such that the pressure distribution is isobaric in the inflowing fluid in the gap between the interior of the distributor tube (1) and the shell surface of the pressure distributor.

18. The apparatus as claimed in claim 15, wherein the pressure distributor (21) consists of a one-piece paraboloid of revolution, of which the internal diameter associated with a given length section k is determined by the equation $d_1^2 = d_0^2 + iD^2/n$, with the number $n = L/k$ of the length sections k, and with a predetermined total length L, maximum internal diameter D, a predetermined length of a length section k of 10 mm, and $i = 0, 1, 2 \ldots n$.

19. The apparatus as claimed in claim 15, wherein the rotationally symmetrical pressure distributor (22) is a cone.

## Revendications

1. Procédé d'introduction uniforme d'un fluide dans un bain de fluide au moyen d'un tube répartiteur à surface cylindrique perforée, caractérisé en ce que le flux massique du fluide est divisé en courants partiels lors de son entrée dans le tube répartiteur et est guidé le long de l'axe du tube et sur l'étendue de la périphérie du tube répartiteur de façon telle que, perpendiculairement à l'axe du tube, il s'établit un flux volumique dont l'écoulement sort d'une manière uniforme.

2. Procédé suivant la revendication 1, caractérisé en ce que les courants partiels sont répartis en volumes uniformes le long de l'axe du tube et parallèlement à cet axe.

3. Procédé suivant la revendication 2, caractérisé en ce que le courant de fluide est introduit dans le tube répartiteur par une face frontale et en ce que le flux massique ou les courants partiels du fluide sont cloisonnés d'une manière étanche sur les faces des volumes qui sont opposées à la face frontale et ils sont déviés transversalement à l'axe du tube.

4. Procédé suivant la revendication 3, caractérisé en ce qu'avant de sortir par les perforations du tube répartiteur, chacun des courants partiels déviés est réparti le long d'un secteur d'introduction et sur l'étendue de la périphérie intérieure du tube répartiteur en ce qui concerne l'écoulement.

5. Procédé d'introduction uniforme d'un fluide dans un bain de fluide au moyen d'un tube répartiteur à surface cylindrique perforée, caractérisé en ce qu'à l'intérieur du tube répartiteur et sur l'étendue de la longueur d'introduction de ce tube, le flux massique du fluide rencontre les mêmes rapports de pression en direction axiale d'écoulement comme en direction radiale d'écoulement.

6. Procédé suivant la revendication 5, caractérisé en ce que la pression d'écoulement du fluide est maintenue constante sur l'étendue de la longueur du tube répartiteur au moyen d'éléments tubulaires rapportés appropriés à section transversale décroissante de passage.

7. Dispositif de mise en oeuvre du procédé suivant une ou plusieurs des revendications 1 à 4, comprenant un tube répartiteur perforé sur l'étendue de sa surface cylindrique, caractérisé en ce que le tube répartiteur perforé (1) entoure un tube-enveloppe (7) qui est divisé en chambres d'écoulement (4), en ce que chaque chambre d'écoulement (4) est délimitée par deux plaques (11) en anneau circulaire et communique avec un secteur d'introduction (14) et en ce que, du côté d'entrée du tube répartiteur (1), il est disposé, sous la forme d'une pièce rapportée profilée, un répartiteur de flux volumique (2) qui divise le flux massique introduit en courants partiels destinés aux chambres d'écoulement.

8. Dispositif suivant la revendication 7, caractérisé en ce que le répartiteur de flux volumique (2) est une pièce rapportée profilée en étoile à six à huit branches comportant des nervures radiales de répartiteur qui partent d'une ligne centrale commune et en ce que, par ses nervures de répartiteur (3), la pièce rapportée profilée divise la section transversale du flux massique introduit en six à huit sections transversales d'entrée d'écoulement de mêmes dimensions.

9. Dispositif suivant la revendication 8, caractérisé en ce que chaque section transversale d'entrée d'écoulement constitue l'ouverture d'entrée d'un secteur d'introduction (14) qui mène dans la chambre d'écoulement (4) associée et en ce que les chambres d'écoulement (4) ont la même longueur, chaque chambre d'écoulement (4) comprenant une plaque de déviation (6) qui s'étend sur l'étendue du secteur d'introduction (14) le long de l'axe (13) du tube et parallèlement à cet axe et qui, avec des parois de chambre (12) du secteur d'introduction (14), constitue deux fentes (8) de sortie de la chambre d'écoulement (4) qui sont parallèles entre elles et débouchent dans un espace annulaire (9) situé entre le tube répartiteur (1) et le tube-enveloppe (7).

10. Dispositif suivant la revendication 7, caractérisé en ce que, dans chaque secteur d'introduction (14) et transversalement à la direction d'écoulement, il est disposé deux surfaces d'appui (5) qui font saillie au-delà de la surface périphérique du tube-enveloppe (7) et sur lesquelles la plaque de déviation (6) prend appui.

11. Dispositif suivant la revendication 10, caractérisé en ce que la plaque de déviation (9) est perforée.

12. Dispositif suivant la revendication 7, caractérisé en ce que les plaques (11) en anneau circulaire centrent le répartiteur de flux volumique (2) par rapport au tube répartiteur (1).

13. Dispositif suivant la revendication 7, caractérisé en ce que les fentes (10) du tube, qui s'étendent transversalement à l'axe (13) du tube répartiteur (1) dans la surface cylindrique de ce tube, constituent les perforations du tube répartiteur.

14. Dispositif suivant la revendication 7, caractérisé en ce que les chambres d'écoulement (4) sont décalées en étoile le long de l'axe (13) du tube.

15. Dispositif de mise en oeuvre du procédé suivant l'une des revendications 5 et 6, comprenant un tube répartiteur perforé sur l'étendue de sa surface cylindrique, caractérisé en ce que le tube répartiteur perforé (1) entoure un répartiteur de pression (15 ; 21 ; 22) à symétrie de révolution qui est centré à la façon d'une étoile au moyen de nervures (17) dans le tube répartiteur (1), qui a un diamètre croissant de l'ouverture d'entrée (23) à la surface frontale de fermeture (24) et qui est monté sur cette surface frontale de fermeture (24).

16. Dispositif suivant la revendication 15, caractérisé en ce que le répartiteur de pression( 15) est constitué de plusieurs étages de répartiteur de pression (18, 19, 20), en ce que les étages de répartiteur de pression (18, 19, 20) sont des cylindres et sont réunis entre eux par des épaulements (16) de forme tronconique et en ce que le cylindre (18) situé le plus près de l'ouverture d'entrée (23) est fermé par un paraboloïde de révolution (25).

17. Dispositif suivant la revendication 15, caractérisé en ce que le répartiteur de pression (15 ; 21 ; 22) est agencé de façon telle que la répartition de pression dans le fluide s'écoulant à l'entrée est isobare dans la fente située entre la face intérieure du tube répartiteur (1) et la surface cylindrique du répartiteur de pression.

18. Dispositif suivant la revendication 15, caractérisé en ce que le répartiteur de pression (21) est constitué d'un paraboloïde de révolution d'une seule pièce dont le diamètre intérieur $d_i$ correspondant à un segment longitudinal déterminé k est déterminé par l'équation $d_i^2 = d_0^2 = iD^2/n$, le nombre n étant égal à $n = L/k$ pour le segment longitudinal k, pour une longueur totale préfixée L, un diamètre intérieur maximal D, une longueur préfixée d'un segment longitudinal k égale à 10 mm et pour i = 0, 1, 2, ... n.

19. Dispositif suivant la revendication 15, caractérisé en ce que le répartiteur de pression (22) à symétrie de révolution est un cône.

Fig. 1

Fig.2

Fig. 3

Fig. 4

Fig. 5

Fig. 6

Fig. 7